## Europäisches Patentamt
## European Patent Office
## Office européen des brevets

(19)

(11) Numéro de publication: **0 143 024**
**B1**

(12) **FASCICULE DE BREVET EUROPÉEN**

(45) Date de publication du fascicule du brevet:
20.05.87

(51) Int. Cl.⁴: **G 06 G 7/184, H 03 H 19/00**

(21) Numéro de dépôt: **84402014.9**

(22) Date de dépôt: **08.10.84**

(54) Intégrateur exponentiel à constante de temp élevée, réalisé avec des capacités commutées.

(30) Priorité: **14.10.83 FR 8316382**

(43) Date de publication de la demande:
**29.05.85 Bulletin 85/22**

(45) Mention de la délivrance du brevet:
**20.05.87 Bulletin 87/21**

(84) Etats contractants désignés:
**DE FR GB IT NL**

(56) Documents cité:
**DE-A-1 498 072**

**MICROELECTRONICS JOURNAL, vol. 13, no. 4, juillet-août 1982, pages 37-40, Kirkcaldy, GB; R. GREGORIAN: "An offset-free switched-capacitor biquad"**
**PROCEEDINGS OF THE IEEE, vol. 67, no. 6, juin 1979, pages 961-963, IEEE, New York, US; A.M. SOLIMAN et al.: "On the active compensation of noninverting integrators"**
**IEEE TRANSACTIONS ON CIRCUITS AND SYSTEMS, vol. CAS-28, no. 10, octobre 1981, pages 947-953, IEEE, New York; US; A. KNOB et al.: "Analysis of switched-capacitor networks in the frequency domain using continuous-time two-port equivalents"**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Caillon, Christian, THOMSON- CSF SCPI 173, bld Haussmann, F-75379 Paris Cédex 08 (FR)**
Inventeur: **Fensch, Thierry, THOMSON- CSF SCPI 173, bld Haussmann, F-75379 Paris Cedex 08 (FR)**
Inventeur: **Guillaume, Pascal, THOMSON- CSF SCPI 173, bld Haussmann, F-75379 Paris Cedex 08 (FR)**

(74) Mandataire: **Guérin, Michel, THOMSON- CSF SCPI 19, avenue de Messine, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

# 0 143 024

## Description

La présente invention concerne les circuits intégrés à capacités commutées qui, parmi beaucoup d'applications possibles, permettent notamment de réaliser des fonctions de filtrage.

Dans certains cas, on peut avoir besoin d'obtenir une constante de temps élevée en réponse à un échelon de tension continue, ce que l'on réaliserait tout simplement dans un circuit non échantillonné, par une association d'une résistance R en série avec une capacité C, et qu'on pourrait réaliser, en circuits à capacités commutées, par une capacité commutée (remplaçant la résistance) en série avec une capacité non commutée. On obtient ainsi une courbe d'intégration exponentielle dont la constante de temps est le produit RC de la résistance par la capacité, égal à C/Cefe si Ce est la capacité commutée, échantillonnée à une fréquence fe, remplaçant la résistance R.

Lorsqu'on veut une constante de temps élevée, on est donc limité par les valeurs possibles en circuit intégré des paramètres C, Ce et fe; concrètement, on ne peut guère descendre, la fréquence d'échantillonnage au dessous de 1 kilohertz, et la capacite Ce au dessous de 0,1 picofarad; d'un autre côté, la capacite C ne pourra pas monter au dessus de 50 picofarads qui correspondent déjà à l'utilisation d'une surface importante de circuit intégré. Ces valeurs conduisent à une constante de temps de 0,5 seconde. Si on veut une valeur supérieure, on est obligé de recourir à une capacité C extérieure au circuit integré, ce qu'on ne souhaite pas (bien que le problème puisse être alors totalement résolu) pour ne pas être obligé de prévoir une borne d'accès extérieur supplémentaire dans le circuit intégré.

La présente invention propose donc un circuit intégré permettant, sans nécessiter une augmentation de valeur de la capacité non commutée, de multiplier par un facteur important la constante de temps susceptible d'être obtenue avec cette capacite.

Ce circuit d'integration exponentielle à capacités commutées comporte trois ensembles à capacités commutées reliés d'un côté à un point commun, le premier ensemble étant relié par ailleurs à une entrée du circuit, le second à la sortie d'un amplificateur operationnel monté en suiveur de tension à gain unitaire, et le troisième étant relié à une sortie du circuit et à une entrée non inverseuse de l'amplificateur opérationnel, une capacité non commutée étant connectée entre la sortie du circuit et une masse électrique.

Ce circuit réalise bien une intégration exponentielle, avec une constante de temps relativement importante lorsque la valeur de la capacité commutée du troisième ensemble est beaucoup plus petite que celle du second.

Parmi les applications possibles de l'invention, on peut citer notamment la réalisation de bascules monostables pour effectuer des temporisations de durées importantes.

D'autres caracteristiques et avantages de l'invention apparaîtront à la lecture de la description détaillée qui suit et qui est faite en référence aux dessins annexés dans lesquels:
- la figure 1 représente un mode de réalisation de l'invention;
- la figure 2 représente un autre mode de réalisation de l'invention.

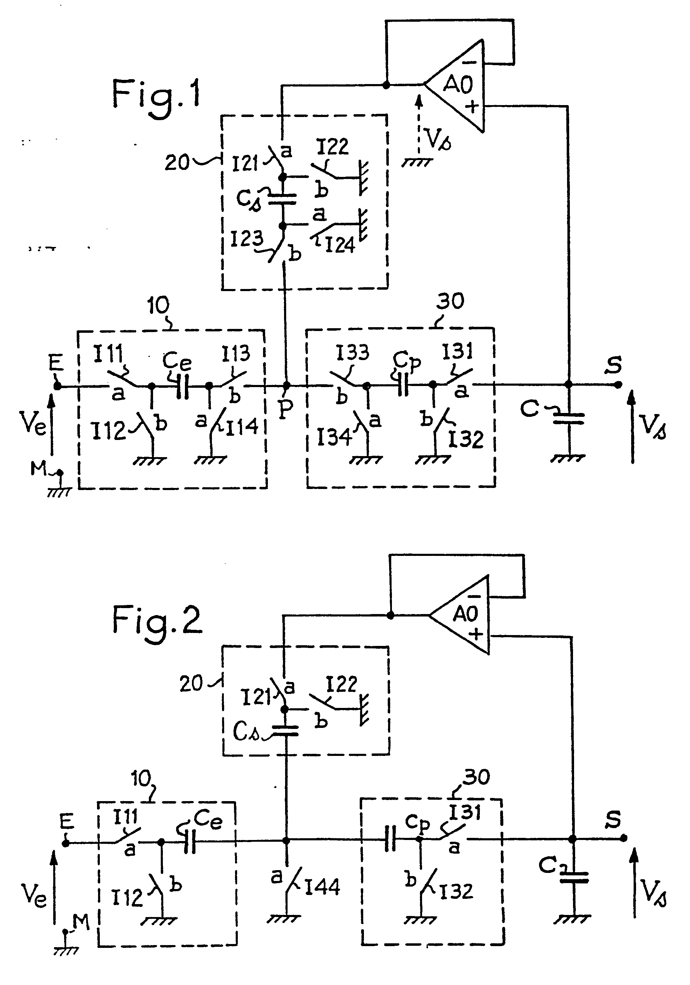

Le circuit de base selon l'invention, représenté à la figure 1 comprend:
- une borne d'entrée E et une borne de masse M, le signal d'entrée (tension Ve) étant appliqué entre ces deux bornes;
- une borne de sortie S, le signal de sortie (tension Vs) étant prélevé entre cette borne et la masse;
- un amplificateur opérationnel AO monté en suiveur de tension, sa sortie reliée directement à son entrée inverseuse; son entrée non-inverseuse est reliée à la borne de sortie S;
- un premier ensemble 10 à capacité commutée constitué par une capacité Ce et quatre interrupteurs actionnés deux à deux selon deux phases de fermeture disjointes a et b à chaque période d'échantillonnage du circuit; la phase de fermeture a ou b de chaque interrupteur du circuit est indiquée à côté de cet interrupteur; l'ensemble 10 est connecté entre l'entrée E et un point commun P du circuit; l'ensemble 10 correspond en fait à la simulation par capacité commutée d'une résistance de valeur 1/FCe, où F est la fréquence d'échantillonnage;
- un deuxième ensemble 20 à capacité commutée, constitué par use capacité Cs et quatre interrupteurs dont deux sont fermés pendant la phase a et deux pendant la phase b; l'ensemble 20 a une constitution identique à celle de l'ensemble 10 mais est connecté entre la sortie de l'amplificateur AO et le point commun P; il correspond à la simulation d'une résistance de valeur 1/FCs
- un troisième ensemble 30 à capacité commutée, constitué par une capacité Cp et quatre interrupteurs dont deux sont fermés pendant la phase a et deux pendant la phase b; l'ensemble 30 a une constitution identique aux ensembles 10 et 20 mais est connecté entre la sortie S du circuit et le point commun P; il correspond à la simulation d'une résistance 1/FCp.

On peut décrire plus précisément les interrupteurs des ensembles 10, 20 et 30 en spécifiant que, pour l'ensemble 10, une borne de la capacité Ce est reliée par un interrupteur I11 à l'entrée E et par un interrupteur I12 à la masse; l'autre borne de la capacité est reliée par un interrupteur I13 au point commun P et par un interrupteur I14 à la masse; les interrupteurs I11 et I14 sont fermés pendant la phase a; les deux autres pendant la phase b.

Pour l'ensemble 20, les interrupteurs correspondant aux interrupteurs I11, I12, I13, I14, sont désignés par I21, I22, I23, I24, et, pour l'ensemble 30, ils sont désignés par I31, I32, I33, I34 respectivement.

Le fonctionnement du circuit est le suivant: au départ, on peut supposer que toutes les capacités sont déchargées, que Ve = 0 et Vs = 0.

2

0 143 024

On applique un échelon de tension continue Ve à un instant t = 0, et on va voir comment la tension de sortie Vs subit une montée exponentielle.

A la première période d'échantillonnage, durant la phase a, la capacité Ce prend une charge CeVe; les autres restent déchargées car elles voient Vs = 0 a leurs bornes. A la phase b, la charge de Ce se répartit, proportionnellement à leurs valeurs respectives, entre les capacités Ce, Cp et Cs qui sont en effet alors toutes connectées en parallèle entre le point commun P (isolé) et la masse. Notamment, la capacité Cp prend une charge CpCeVe/Ce + Cs + Cp.

A la phase a de la période suivante, la capacité Cp vient en parallèle sur la capacité son commuté C et la charge de la capacité Cp se répartit, proportionnellement à leurs valeurs respectives entre Cp et C. La capacité non commutée C prend donc une charge (CpCeVe/Ce + Cs + Cp)(C/C + Cp).

Il apparaît donc alors entre la borne de sortie S et la masse, durant cette deuxième phase a, une tension de sortie Vs = CpCeVe/(Ce + Cs + Cp)(C + Cp).

Cette tension, apparaît également en sortie de l'amplificateur operationnel AO qui est monté en suiveur à gain unitaire, de sorte que la capacité Cs prend alors une charge CsVs. Les charges prises par les capacités commutées sont alors CeVe, CsVs et CpVs respectivement et, durant la phase b suivante, comme ces capacités se retrouvent en parallèle, la somme des charges se répartit à nouveau entre Ce, Cs et Cp proportionnellement à leur valeur; enfin, durant la phase a de la troisième période d'échantillonnage, la capacité Cp transfère une partie de sa nouvelle charge à la capacité non commutée C, augmentant la tension de sortie Vs qui se met à croître, de période en période en suivant, comme on va le montrer, une courbe de montéee exponentielle dont la constante de temps est T(C + Cp)(Ce + Cs + Cp)/CeCp où T est la période d'échantillonnage.

Pour mettre en évidence cette période, on peut examiner ce qui se passe entre la n$^{ième}$ période d'échantillonnage et la période suivante.

On appelle Vs(n), la tension de sortie à la fin de la n$^{ième}$ période et Vs(n + 1) la tension à la fin de la période suivante.

A la phase a de la n$^{ième}$ période, on a une charge CeVe sur Ce, CsVs(n) sur Cs, CpVs(n) sur Cp et CVs(n) sur C.

A la phase b, une charge CeVe + CsVs(n) + CpVs(n) se répartit entre Ce, Cs et Cp selon leurs valeurs respectives.

Cp prend donc une charge:
[CeVe + CsVs(n) + CpVs(n)] Cp/(Ce + Cs + Cp)
A la phase à de la période suivante, Cp vient en parallèle avec C; la somme de leurs charges respectives est:
CVs(n) + [CeVe + CsVs(n) + CpVs(n)] Cp/(Ce + Cs + Cp).

Cette somme se répartit entre C et Cp en proportion de leurs valeurs et établit sur la sortie S un nouveau potentiel Vs(n + 1) tel que la nouvelle charge CVs(n + 1) de la capacité C soit une proportion C/C + Cp de la somme ci-dessus:

$$CVs(n + 1) = \tfrac{C}{C + Cp} (CVs(n) + [CeVe + CsVs(n) + CpVs(n)] Cp/(Ce + Cs + Cp))$$

$$Vs(n + 1) = \tfrac{CVs(n)}{C + Cp} + {}^{(Cs + Cp) Cp Vs(n)} + \tfrac{CeCpVe}{(Ce + Cs + Cp)9C + Cp}$$

$$Vs(n + 1) = \tfrac{C + Cp - Cp}{C + Cp} Vs(n) + \tfrac{(Cs + Cp + Ce)Cp - CeCp}{(C + Cp) (Ce + CCs + Cp)} Vs(n) + \tfrac{CeCpVe}{(Ce + Cs + Cp)(C + Cp)}$$

$$Vs(n + 1) = Vs(n) - \tfrac{CeCp Vs(n)}{(C + Cp) (Ce + Cs + Cp)} + \tfrac{CeCp Ve}{(Ce + Cs + Cp)(C + Cp)}$$

$$Vs(n + 1) - Vs(n) = - \tfrac{CeCp}{(C + Cp)(Ce + Cs + Cp)} (Vs(n) - Ve)$$

Comme la période d'échantillonnage T = 1/F du circuit est très brève devant les temps d'intégration considérés, on peut considérer la variation de tension Vs(n + 1) - Vs(n) durant l'intervalle T comme une variation différentielle dVs pendant un intervalle de temps dt, et écrire l'équation différentielle suivante:
dVs/dt = - K [Vs(t) - Ve]
avec K = $\tfrac{CeCp}{(C + Cp) (Ce + Cs + Cp) T}$
équation dont la solution est
Vs = Ve (1 - e$^{-Kt}$),
qui montre bien que lorsqu'on applique un échelon de tension Ve à l'entrée, la tension de sortie Vs tend exponentiellement (en fait en marches d'escalier puisque le système est échantillonné) vers la valeur Ve, avec une constante de temps égale à 1/K donc à:
$\tfrac{(C + Cp) (Ce + Cs + Cp) T}{CeCp}$

Il faut noter que si l'intégration exponentielle était réalisée simplement par une capacité non commutée C et une capacité commutée Ce (équivalente à une résistance de valeur T/Ce), la constante de temps d'intégration serait TC/Ce.

Ici, en supposant que Cp est petit devant C, la constante de temps obtenue est pratiquement multipliée par un facteur (Ce + Cs + Cp)/Cp.

Dans le cas où on cherche à obtenir une grande constante de temps, on choisira une valeur de Ce faible et une valeur de C élevée (comme on l'aurait fait de toutes façons avec un circuit RC simple), et on agira sur le

3

facteur multiplicatif (Ce + Cs + Cp)/Cp en choisissant une valeur de capacité Cs relativement importante et une valeur de capacité Cp relativement faible.

A titre d'exemple, en supposant qu'on ne veuille pas de capacité plus petite que 0,5 picofarad, ni de capacité plus grande que 50 picofarads, on pourra, avec Ce et Cp égales à 0,5 pf et Cs égale 50 pf, obtenir une constante de temps 100 fois plus grande qu'avec un circuit ne comportant que les capacités Ce et C.

Un exemple numérique peut être donné: avec une fréquence d'échantillonnage de 1 kilohertz, des capacités Ce et Cp de 0,5 picofarad et des capacités C et Cs de 25 picofarads, la constante de temps obtenue est de 2,6 secondes.

Une variante de réalisation représentée à la figure 2 est obtenue à partir de la constatation qu'il y a une certaine redondance des interrupteurs I13, I14, I23, I24, I33, I34: dans la phase b, les capacités sont toutes reliées d'un côté au point commun P tandis que dans la phase a elles sont toutes reliées de ce côté à la masse. Les trois armatures des capacités du côté du point commun P sont donc toujours reliées les unes aux autres et il suffit de prévoir une connexion permanente entre ces armatures et le point P, avec un interrupteur I44 qui relie ce point P à la masse durant la phase a.

Les ensembles 10, 20, 30 à capacités commutées sont donc simplifiés puisqu'ils ne comportent chacun plus que deux interrupteurs, mais le circuit est plus sensible à l'influence des capacités parasites des interrupteurs I12, I22, I32.

On peut envisager de prévoir que la constante de temps de décharge de la capacité C soit réduite par rapport à la constante de temps de montée, en utilisant par exemple un interrupteur (non représenté) pour connecter le point commun P à la masse, pendant toute la durée de retour à zéro de la tension Vs; la constante de temps de descente est alors TC/Cp. Cet interrupteur est fermé indépendamment des phases d'échantillonnage, contrairement à l'interrupteur I44 de la figure qui est fermé pendant les phases a seulement.

Enfin, on peut prévoir une possibilité de programmation de la constante de temps en prévoyant non pas une capacité Cp et une capacité Cs, mais plusieurs champs de capacités Cp et/ou Cs permettant de choisir de connecter dans le circuit des valeurs de capacites désirées en fonction des besoins.

### Revendications

1. Circuit d'intégration exponentielle à capacités commutées, caractérisé en ce qu'il comporte trois ensembles à capacité commutée reliés d'un côté à un point commun (P), le premier ensemble (10) étant relié par ailleurs à une entrée (E) du circuit, le second (20) à la sortie d'un amplificateur opérationnel (AO) monté en suiveur de tension à gain unitaire, et le troisième (30) étant relié à une sortie (S) du circuit et à une entrée non inverseuse de l'amplificateur opérationnel, une capacité non commutée (C) étant connectée entre la sortie (S) du circuit et une masse électrique.

2. Circuit selon la revendication 1, caractérisé en ce que la valeur de la capacité (Cp) du troisième ensemble est beaucoup plus petite que celle du second (Cs).

3. Circuit selon l'une des revendications 1 et 2, caractérisé en ce que chaque capacité commutée (Ce, Cs, Cp) est reliée à des interrupteurs actionnés selon deux phases distinctes disjointes (a et b) de manière que dans une première phase (a), les capacités soient reliées, du côté du point commun (P), à la masse (M), et, de l'autre côté, respectivement à l'entrée (E), à la sortie de l'amplificateur (AO), et à la sortie (S) du circuit, et que, dans une deuxième phase (b), les capacités commutées (Ce, Cs, Cp) soient reliées d'un côté au point commun (P) isolé alors de tout autre élément de circuit, et de l'autre côté à la masse (M).

4. Circuit selon la revendication 3, caractérisé en ce que chaque capacité commutée est reliée, du côté du point commun, à un premier interrupteur respectif (I14, I24, I34) capable de la relier dans une première phase à la masse, ainsi qu'à un second interrupteur respectif (I13, I23, I33) capable de la relier dans une autre phase (b) au point commun.

5. Circuit selon la revendication 3, caractérisé en ce que chaque capacité commutée est directement connectée au point commun, et qu'un interrupteur unique (I44) pour les trois capacités est prévu pour relier, dans la première phase, le point commun à la masse.

6. Circuit selon l'une des revendications 1 à 5, caractérisé en ce qu'il est prévu un interrupteur supplémentaire susceptible d'être fermé ou ouvert indépendamment des deux phases de commutation des capacités commutées pour relier le point commun à la masse et permettre le retour de la tension de sortie à zéro avec une constante de temps plus rapide que la constante de temps normale de montée de cette tension de sortie.

### Patentansprüche

1. Exponentialintegrationskreis mit geschalteten Kondensatoren, dadurch gekennzeichnet, daß er drei Schalteinheiten mit je einem geschalteten Kondensator aufweist, die einerseits an einen gemeinsamen Punkt (P) angeschlossen sind und von denen die erste Einheit (10) andererseits an einen Eingang (E) des Kreises, die zweite (20) an den Ausgang eines als Trennverstärker mit Einheitsverstärkung geschalteten

# 0 143 024

Operationsverstärkers (AO) und die dritte (30) an einen Ausgang (S) des Kreises sowie an einen nichtinvertierenden Eingang des Operationsverstärkers angeschlossen ist, wobei ein nicht geschalteter Kondensator (C) zwischen dem Ausgang (S) des Kreises und einem elektrischen Masseanschluß eingefügt ist.

2. Integrationskreis nach Anspruch 1, dadurch gekennzeichnet, daß der Kapazitätswert des Kondensators (Cp) der dritten Einheit deutlich kleiner als der des Kondensators (Cs) der zweiten Einheit ist.

3. Integrationskreis nach einem der Ansprüche 1 und 2, dadurch gekennzeichnet, daß jeder geschaltete Kondensator (Ce, Cs, Cp) an Schalter angeschlossen ist, die gemäß zwei unterschiedlichen und nicht überlappenden Phasen (a und b) betätigt werden, so daß in einer ersten Phase (a) die Kondensatoren auf der Seite des gemeinsamen Punkts (P) an Masse (M) liegen und auf der jeweils anderen Seite am Eingang (E) bzw. am Ausgang des Verstärkers (AO) bzw. am Ausgang (S) des Kreises liegen, und daß in einer zweiten Phase (b) die geschalteten Kondensatoren (Ce, Cs, Cp) einerseits an dem dann von jedem anderen Element des Kreises isolierten gemeinsamen Punkt (P) und andererseits an Masse (M) liegen.

4. Integrationskreis nach Anspruch 3, dadurch gekennzeichnet, daß jeder geschaltete Kondensator auf der Seite des gemeinsamen Punkts an je einen ersten Unterbrecher (I14, I24, I34), der diesen Kondensator in einer ersten Phase an Masse legen kann, sowie an jeweils einen zweiten Unterbrecher (I13, I23, I33) angeschlossen ist, der den jeweiligen Kondensator in einer anderen Phase (b) an den gemeinsamen Punkt anlegen kann.

5. Integrationskreis nach Anspruch 3, dadurch gekennzeichnet, daß jeder geschaltete Kondensator unmittelbar an dem gemeinsamen Punkt angeschlossen ist und daß ein gemeinsamer Unterbrecher (I44) für die drei Kondensatoren vorgesehen ist, um in der ersten Phase den gemeinsamen Punkt an Masse zu legen.

6. Integrationskreis nach einem der Ansprüche 1 bis 5, dadurch gekennzeichnet, daß ein weiterer Unterbrecher vorgesehen ist, der unabhängig von den beiden Schaltphasen der geschalteten Kondensatoren geschlossen oder geöffnet werden kann, um den gemeinsamen Punkt an Masse zu legen und die Rückkehr der Ausgangsspannung auf Null mit einer kürzeren Zeitkonstante als die normale Anstiegszeitkonstante dieser Ausgangsspannung zu erlauben.

## Claims

1. An exponential integrator circuit having switched capacitors, characterized in that it comprises three units, each including one switched capacitor and connected respectively at one side to a common point (P), the first unit (10) being connected at its other side to an input (E) of the circuit, the second unit (20) to the output of an operational amplifier (AO) mounted as voltage follower and having unitary gain, and the third unit (30) to an output (S) of the circuit and to a non-inverting input of the operational amplifier, a capacitor (C) which is not switched being connected between the output (S) of the circuit and an electrical earth terminal.

2. A circuit according to claim 1, characterized in that the capacity of the capacitor (Cp) of the third unit is substantially smaller than that of the capacitor (Cs) of the second unit.

3. A circuit according to one of claims 1 and 2, characterized in that each switched capacitor (Ce, Cs, Cp) is connected to switches which are closed according to two distinct and not overlapping phases (a and b) in such a manner that during a first phase (a), the capacitors are connected on the side of the common point (P) to earth (M) and at the other side to the input (E), to the output of the amplifier (AO) or to the output (S) of the circuit respectively, and that during a second phase (b), the switched capacitors (Ce, Cs, Cp) are connected on the one side to the common point (P) which is then insulated from any other circuit element, and on the other side to earth (M).

4. A circuit according to claim 3, characterized in that each switched capacitor is connected on the side of the common point to a first respective switch (I14, I24, I34) which is capable to connect it, during a first phase, to earth, as well as to a second switch (I13, I23, I33) respectively capable to connect it, during another phase (b), to the common point.

5. A circuit according to claim 3, characterized in that each switched capacitor is directly connected to the common point and that a common switch (I44) is provided for the three capacitors in order to connect the common point during the first phase to earth.

6. A circuit according to one of claims 1 to 5, characterized in that an additional switch is provided which can be closed or opened independently from the two phases for switching the switched capacitors, in order to connect the common point to earth and to allow the output voltage to return to zero with a time constant which is substantially shorter than the normal time constant at which this output voltage rises.

Fig.1

Fig.2